# EUROPEAN PATENT APPLICATION

(11) **EP 2 169 734 A1**
(43) Date of publication of application: **31.03.2010**
(21) Application number: 08165266.1
(22) Date of filing: 26.09.2008
(51) Int. Cl.: H01L 37/04

(54) **Electricity generation system**

(71) Applicant: ABB Research Ltd., 8050 Zürich (CH)
(72) Inventor: Dahlgren, Mikael, SE-724 64, VÄSTERÅS (SE); Russberg, Gunnar, SE-724 62, VÄSTERÅS (SE); Thorburn, Stefan, SE-723 48, VÄSTERÅS (SE)
(74) Representative: Fritzon, Rolf

(57) **Abstract**

An electricity generation system (11) comprises a low frequency alternating heat and cold distribution system (12) provided for alternately distributing heat and cold at low frequency; a heat-electricity conversion system (13) operatively connected to the low frequency alternating heat and cold distribution system and provided for generating electricity in response to the alternately distributed heat and cold; an electric power delivery system (14) operatively connected to the heat-electricity conversion system and provided for distributing the generated electricity; and a process control system (15) operatively connected to the low frequency alternating heat and cold distribution system, to the heat-electricity conversion system, and to the electric power delivery system in order to control the operations thereof.

## Description

### TECHNICAL FIELD OF THE INVENTION

The present invention generally relates to an electricity generation system for converting thermal energy to electric energy.

### DESCRIPTION OF RELATED ART AND BACKGROUND OF THE INVENTION

Apparatuses for transforming thermal energy directly into electric energy using a minimum of moving parts have been known since long.

At the end of the 19'th century, Edison and Tesla described devices based on thermomagnetic materials for converting thermal energy into electricity. Edison's pyro-magnetic generator as described in the British patent No. 16709 includes a thermomagnetic working material, means for magnetizing the working material, sources of heat and cold connected to the working material, and a winding enclosing the working material and in which an alternating electric current is induced by thermally cycling the working material. Tesla discloses in U.S. patent No. 428,057 some improvements of Edison's generator by suggesting an alternative heat exchanging mechanism.

Chilowsky discloses in U.S. patent No. 2,510,806 a device for thermomagnetic energy conversion, wherein the temperature variations are achieved by hot and cold fluids in a closed fluid circuit.

Bartels discloses in German patent No. 23 47 377 a device similar to Edison's generator, but suggests gadolinium as magnetic working medium. In one embodiment a permanent magnet is provided to create the magnetic flux in the thermomagnetic material and in another embodiment a battery is used to induce a current in a coil to thereby form an electromagnet to create the magnetic flux.

While the apparatuses described above do convert thermal energy directly to electric energy, they seem not to be efficient, compact, optimized for practical use, and/or cost-efficient to manufacture.

### SUMMARY OF THE INVENTION

It is an object of the present invention to provide an electricity generation system, which has a simplified, yet improved, structure and operation.

It is a particular object of the invention to provide such electricity generation system, which provides for efficient conversion of energy.

It is a further object to provide such electricity generation system, which is dynamically controllable, reliable, flexible, and of reasonable cost.

It is a yet further object to provide such electricity generation system, which is adapted for practical use.

These objects, among others, are according to the present invention attained by electricity generation systems as specified in the appended patent claims.

According to one aspect of the invention there is provided an electricity generation system comprises a low frequency alternating heat and cold distribution system provided for alternately distributing heat and cold at low frequency; a heat-electricity conversion system operatively connected to the low frequency alternating heat and cold distribution system and provided for generating electricity in response to the alternately distributed heat and cold; an electric power delivery system operatively connected to the heat-electricity conversion system and provided for distributing the generated electricity; and a process control system operatively connected to the low frequency alternating heat and cold distribution system, to the heat-electricity conversion system, and to the electric power delivery system in order to control the operations thereof.

Such electricity generation system is compact and requires no moving or rotating mechanical parts. The process control system is provided for controlling the operations of the low frequency alternating heat and cold distribution system, the heat-electricity conversion system, and the electric power delivery system in order to optimize the performance of the electricity generation system. Hereby, an efficient conversion of thermal energy to electric energy is obtained.

The present invention is suitable for a large variety of electric power generation by using for example any of waste heat, combustion heat, thermal storage reservoir energy, geothermal energy, solar radiation, solar thermal energy, ocean thermal energy, or energy from nuclear reactions.

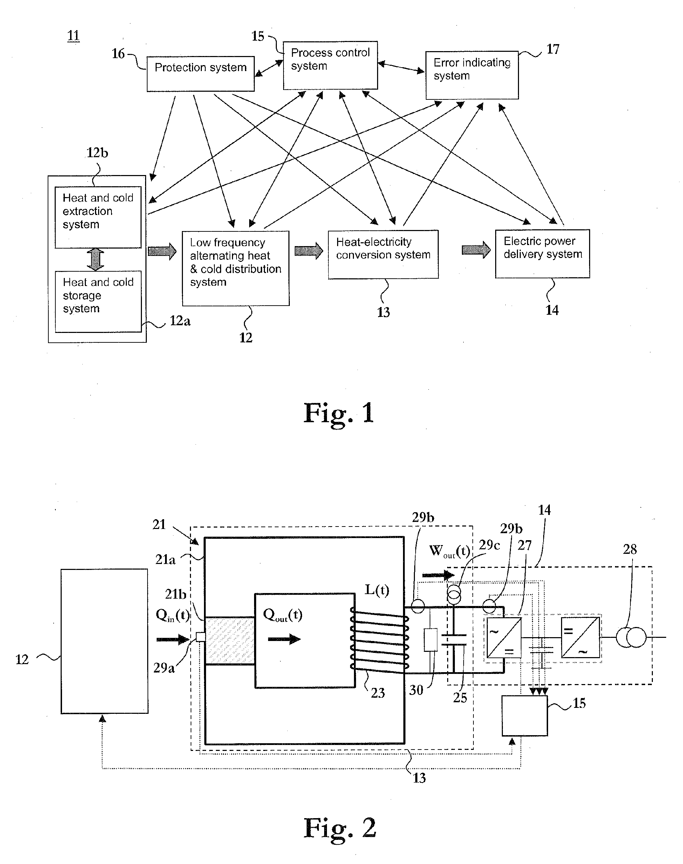

Further characteristics of the invention and advantages thereof, will be evident from the following detailed description of preferred embodiments of the present invention given hereinafter and the accompanying Figs. 1-4, which are given by way of illustration only and thus, are not limitative of the present invention.

### BRIEF DESCRIPTION OF THE DRAWINGS

Fig. 1 displays schematically an electricity generation system according to a general aspect of the present invention.
Fig. 2 displays schematically an electricity generation system according to a particular aspect of the present invention.
Fig. 3 displays schematically an electricity generation system according to another particular aspect of the present invention.
Fig. 4 displays schematically an electricity generation network comprising a collection grid and a plurality of the electricity generation system of any of Figs. 1-3 connected to the collection grid.

Similar reference numerals are used to indicate similar parts and details throughout the embodiments.

### DETAILED DESCRIPTION OF EMBODIMENTS

An electricity generation system 11 according to a general aspect of the present invention, as shown in Fig. 1, comprises a low frequency alternating heat and cold distribution system 12, a heat-electricity conversion system 13, an electric power delivery system 14, and a process control system 15.

The low frequency alternating heat and cold distribution system 12 is configured to alternately distribute heat and cold to the heat-electricity conversion system 13 at low frequency, preferably at a frequency between about 0.1 and 10 Hz. The heat and cold has advantageously a maximum temperature difference between about 5 and 50 K for each conversion in the heat-electricity conversion system 13.

The low frequency alternating heat and cold distribution system 12 may be operatively connected to or comprise a heat and cold storage system 12a for storing heat and cold and a heat and cold extracting system 12b for extracting heat and cold from the heat and cold storage system 12a.

In particular, the heat and cold extracting system 12a is arranged to extract heat from the heat and cold storage system 12a and to extract cold from the heat and cold storage system 12a in response to the availability of heat and/or cold from other sources, such as e.g. waste heat, combustion heat, thermal storage reservoir energy, geothermal energy, solar radiation, solar thermal energy, ocean thermal energy, or energy from nuclear reactions and cold water from a water reservoir or from a river or the ocean.

The heat and cold storage and extracting systems 12a-b may for example be integrated and comprise one or more solar ponds. Alternatively, heat and cold may be stored in other fluids, stone, concrete material, ceramic materials, porous metals, or materials with a clear phase transition such as salts, e.g. LiCl.

The heat-electricity conversion system 13 is operatively connected to the low frequency alternating heat and cold distribution system 12 and is configured to generate electricity in response to the alternately distributed heat and cold. Advantageously, the heat-electricity conversion system 13 comprises a magnetic circuit which includes at least a portion made of a thermomagnetic material, which has a magnetic phase transition temperature between the temperatures of the heat and the cold of the low frequency alternating heat and cold distribution system 12. As the thermomagnetic material is alternately heated above and cooled below the magnetic phase transition temperature of the thermomagnetic material, the reluctance of the magnetic circuit is altered which in turn modulates the magnetic flux of the magnetic circuit. As a result an alternating current is obtained in a coil arranged around the magnetic circuit.

The heat-electricity conversion system 13 may comprise several heat-electricity conversion stages operating in parallel or in series.

The invention is not limited to using thermomagnetic materials only. It can operate with any thermodynamic material that has significantly different properties, preferably electromagnetic properties, for hot and cold states, respectively, to provide a variation of the reluctance of the magnetic circuit. Examples of electromagnetic property changes are for instance a phase transition as disclosed above or a significant parameter variation. Examples of parameters are electromagnetic parameters, mechanical parameters such as e.g. a volume or a pressure change, and/or chemical parameters. The material may be a so-called smart material.

As such the heat-electricity conversion system 13 is a stationary system without movable mechanical parts and comprises a fixedly arranged thermomagnetic material.

The electric power delivery system 14 is operatively connected to the heat-electricity conversion system 13 and is configured to distribute the generated electricity to e.g. an electric grid.

Finally, the process control system 15 is operatively connected to the low frequency alternating heat and cold distribution system 12, to the heat-electricity conversion system 13, and to the electric power delivery system 14 in order to control the operations thereof.

Preferably, the low frequency alternating heat and cold distribution system 12 is provided for alternately distributing the heat and cold periodically, the heat-electricity conversion system 13 is provided for generating the electricity periodically, and the process control system 15 is provided for controlling the period of the generated electricity and the period of the distribution of heat and cold so that one of the periods is n times the other one of the periods, where n is an integer.

Further, the process control system 15 comprises or is connected to one or more sensors for sensing a parameter of one, any, or each of the low frequency alternating heat and cold distribution system 12, the heat-electricity conversion system 13, and the electric power delivery system 14, and is arranged to control another one, any, or each of the low frequency alternating heat and cold distribution system 12, the heat-electricity conversion system 13, and the electric power delivery system 14 in response to the sensed parameter.

The parameter or parameters may include any of a volume flow, mass flow, a temperature, a pressure, a wave shape, a pulse length, a frequency, a phase, a magnetic flux, a voltage, a current, impedance, and/or a power.

The process control system 15 may be arranged to control any of the following parameters: a magnitude or magnitude per time unit of the alternately distributed heat and cold, the frequency of the alternately distributed heat and cold, the temperature of the alternately distributed heat and cold, an active power cycle, an active and/or reactive power of the distributed generated electricity, and/or a frequency and phase of the distributed generated electricity in response to the sensed parameter or the sensed parameters.

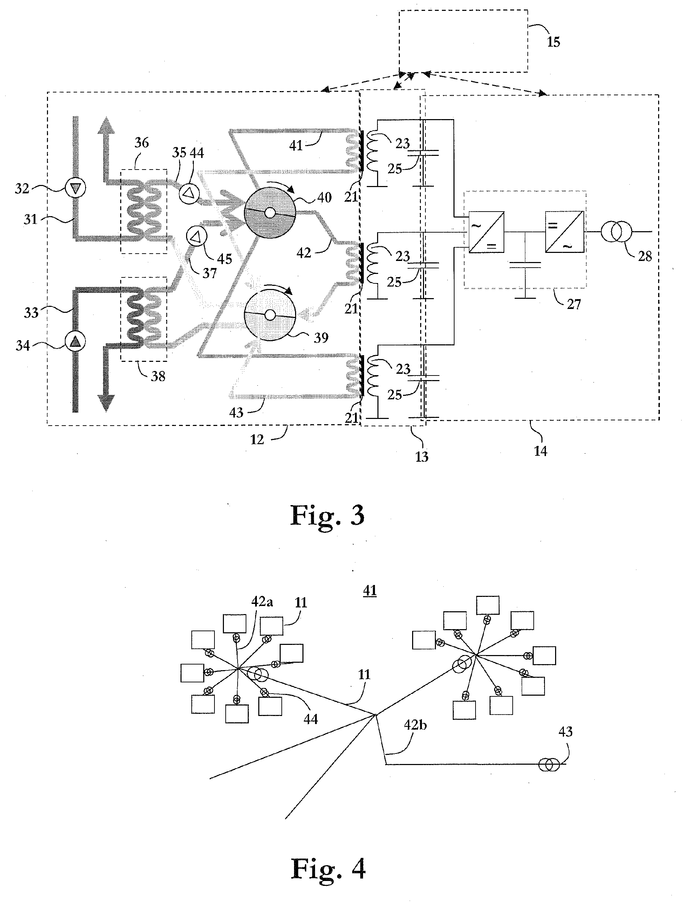

More details regarding sensed and controlled parameters of the electricity generation system of the invention will be discussed below with reference to Figs. 2 and 3.

Further, the electricity generation system 11 comprises a protection system 16 is operatively connected to the low frequency alternating heat and cold distribution system 12, the heat-electricity conversion system 13, the electric power delivery system 14, and/or the process control system 15 for protecting the same. The protection system 16 may, instead of being operatively connected to the process control system 15, be an integral part thereof.

In one embodiment the protection system 16 comprises a leakage sensor for sensing a leakage in the low frequency alternating heat and cold distribution system 12 and is arranged to shut down the low frequency alternating heat and cold distribution system 12 in response to the sensed leakage.

In another embodiment, the protection system 16 comprises a drainage or reservoir for handling a leakage in the low frequency alternating heat and cold distribution system 12.

In yet another embodiment, the protection system 16 comprises a protection circuit including e.g. an arc eliminator to avoid a permanent breakdown in the heat-electricity conversion system 13.

Yet further, the electricity generation system 11 comprises an error indication system 17 is operatively connected to the low frequency alternating heat and cold distribution system 12, the heat-electricity conversion system 13, the electric power delivery system 14, and/or the process control system 15 for indicating an error in the operation of the same. The error indication system 17 may, instead of being operatively connected to the process control system 15, be an integral part thereof.

In one embodiment, the error indication system 17 is arranged to send an alarm to an operator, e.g. a remotely located operator, in response to an indicated error.

In another embodiment, the protection system 16 is provided for breaking a current in the heat-electricity conversion system 13 and/or in the electric power delivery system 14 and/or for changing an active and/or reactive power of the distributed generated electricity as performed by the electric power delivery system 14 in response to an indicated error.

An electricity generation system for transformation of heat into electric energy according to a particular aspect of the present invention is shown in Fig. 2. In particular, the heat-electricity conversion system 13 and the electric power delivery system 14 are detailed.

The heat-electricity conversion system 13 comprises a magnetic circuit 21 and a coil or winding 23 arranged around the magnetic circuit 1.

The magnetic circuit 21 may be substantially of iron or other magnetic material 21a, but includes at least a portion 21b made of a thermomagnetic material, which has a suitable phase transition temperature, e.g. in the interval 0-200 °C. Alternatively, an essential portion of the magnetic circuit 21 or the entire magnetic circuit 21 is of the thermomagnetic material with the suitable phase transition temperature. Examples of magnetic phase transition temperatures are the Curie temperature and the Néel temperature.

The low frequency alternating heat and cold distribution system 12 is configured to vary the temperature in the portion 21b made of the thermomagnetic material with the suitable phase transition temperature alternately above and below the magnetic phase transition temperature of the thermomagnetic material. The low frequency alternating heat and cold distribution system 12 is advantageously a system for circulation, preferably unidirectional or bidirectional continuous circulation, of a medium of alternating temperature, and comprises an arrangement for receiving a hot medium, an arrangement for receiving a cold medium, and at least one arrangement for mixing the hot and cold media. Alternatively, the low frequency alternating heat and cold distribution system 12 is a system for transporting/flowing the medium back and forth through or past the portion 21b made of the thermomagnetic material. An example of a low frequency alternating heat and cold distribution system 12 will be detailed below with reference to Fig. 3.

The variation of temperature above and below the phase transition temperature causes drastic changes of the permeability of the thermomagnetic material and thus a rapid variation of the magnetic reluctance of the magnetic circuit 21. In other words, the magnetization is varied when a constant magnetic field is applied. Provided that a magnetic flux is provided in the magnetic circuit 21, the rapid variation of the reluctance will modulate the magnetic flux, thereby obtaining a rapidly varying magnetic flux in the magnetic circuit 21. As a result a magnetomotive force and an alternating current are obtained in the coil 23.

The magnetic flux can be provided by a permanent magnet or, as in Fig. 2, by an electromagnet. The current for the electromagnet is advantageously taken from the system itself.

To this end, the electric power delivery system 14 comprises a capacitor device 25 connected in parallel with the coil 23. The capacitor device 25 forms a resonant electric circuit with the coil 23, wherein the frequency of the temperature variation above and below the phase transition temperature of the thermomagnetic material is adjusted to optimize the resonant energy transfer to the resonant electric circuit. Hereby, a single coil 23 can be used in the transformation of heat to electric energy and for providing a magnetic flux in the magnetic circuit 21 and as such the capacitor device 23 can also be regarded as part of the heat-electricity conversion system 13.

A part, e.g. a major part, of the current/charge induced in one half of a first thermal cycle is stored by the capacitor device 25 and is used in the following half of the first thermal cycle to generate a magnetic flux in the magnetic circuit 21. This first thermal cycle corresponds advantageously to one half of an electric cycle. The procedure is repeated through a second thermal cycle with current and voltage 180 degrees phase shifted.

The electric power delivery system 14 comprises further a power electronic system 27 operatively connected to the resonant circuit and a transformer 28 interconnected between the power electronic system 27 and an electric grid, to which the electric power delivery system 14 is arranged to deliver the generated electricity.

The power electronic system 27 may comprise a power conversion device, a controllable load, or another power electronic circuit device connected to the capacitor device 25. Such a power conversion device may comprise an AC/DC or AC/AC frequency converter or a power electronic converter including a current or voltage source converter, which encompasses a rectifier and an inverter at the DC side of the rectifier.

Preferably, the power electronic system 27 has a load with an inductive component/capacitive component and a resistive component, each of which being separately and individually controllable. Advantageously, the load can be used to adjust the active and/or reactive power. Additionally, or alternatively, a battery is connected at the DC side. This is particularly advantageous if the power output from the generator is very fluctuating.

The transformer 28 is configured to transform the output voltage and frequency of about 1 kV and 1 Hz from the electricity generation system to a frequency and a voltage (50/60 Hz, 10 kV) suitable for normal grid connection. The rating of the equipment is typically larger than 1 kW.

Preferably, the electricity generation system of the invention is configured for electric power generation in the range of 100 kW to 100 MW, and more preferably in the range of 1-5 MW. Several electricity generation systems may be arranged together to generate electric powers of about 10-50 MW or more. An example of such electricity generation network will be given below with reference to Fig. 4.

The process control system 15 is arranged to control the low frequency alternating heat and cold distribution system 12, the heat-electricity conversion system 13, and the electric power delivery system 14.

To this end, different measurement devices or sensors, such as a thermo sensor 29a, current sensors 29b, and a voltage sensor 29c may be provided to supply the process control system 15 with suitable measurement data.

The thermo sensor 29a may supply the process control system 15 with temperature data instantaneously measured in or at the thermomagnetic material with the suitable phase transition temperature or in or at the low frequency alternating heat and cold distribution system 12. The sensors 29b-c may supply the process control system 15 with voltage and current data instantaneously measured in the resonant circuit and may be realized as current or voltage transformers. Alternatively, the current sensor is a shunt, a LEM module or other device based on the Hall effect, or an optical transformer, and the voltage sensor is a resistive voltage divider.

Hereby, the amplitude and phase of the impedance of the load of the electric power delivery system 14 can be dynamically controlled. The frequency and period of a variation of the impedance is controllable, and so is the frequency and period of the resonance of the resonant circuit.

The process control system 15 may further control a voltage, and/or a current of the heat-electricity conversion system 13 and/or the electric power delivery system 14 in order to control the operation of the heat-electricity conversion system and/or the electric power delivery system.

Further, the process control system 15 may be configured to control the amplitude, phase, and frequency of the variation of the temperature above and below the phase transition temperature.

Still further, the process control system 15 may be provided to initiate the operation of the generator device, i.e. to start the resonant oscillations, e.g. by delivering a current pulse to the magnetic circuit 11.

The system of Fig. 2 may also comprise a protection system and an error indication system as disclosed with reference to the system of Fig. 1. In particular, the protection circuit includes a protection circuit 30 to limit or avoid a breakdown or limit or avoid a permanent failure in the heat-electricity conversion system 13. The protection circuit 30 may be an arc eliminator 30 connected in parallel over the coil 23 and the capacitor device 25 and operable in response to a sensed pressure difference.

The electricity generation system as described above may be compact without essentially any movable mechanical parts and without any conversion to or from mechanical energy. Operation is easily controlled and efficiency may be optimized by adjusting the output power during a cycle.

It shall be appreciated that a plurality of the electricity generation system of Fig. 2 can be integrated to form a multiphase electricity generation system. For instance three electricity generation system of Fig. 2 may be integrated and phase-shifted 120° with respect to one another to form a three-phase electricity generation system.

An example of such a three-phase electricity generation system for transformation of heat into electric energy according to another particular aspect of the present invention is shown in Fig. 3. In particular, the low frequency alternating heat and cold distribution system 12 is detailed.

The heat-electricity conversion system 13, the electric power delivery system 14, and the process control system 15 are only schematically indicated.

The heat-electricity conversion system 13 includes three magnetic circuits 21, each being of the kind described with reference to Fig. 2 and each being operatively connected to a respective resonant circuit including a coil and a capacitor connected in parallel.

The electric power delivery system 14 is a common system interconnecting the three resonant circuits and comprises the power electronic system 27 and the transformer 28.

Similarly, the process control system 15 is advantageously a common control system for the three phases. However, separate control systems may be provided for each phase. Further, the process control system 15 of this invention may be a centralized system taking care of the control of the various parts of the electricity generation system or it may be a distributed system wherein each of the low frequency alternating heat and cold distribution system 12, the heat-electricity conversion system 13, and the electric power delivery system 14 has its own control apparatus.

The low frequency alternating heat and cold distribution system 12 comprises an outer part, which includes a first external pipe arrangement 31, in which a hot medium such as a hot fluid is circulated by a feed pump 32, and a second external pipe arrangement 33, in which a cold medium such as cold fluid is circulated by a feed pump 34. The hot and cold fluids of the outer part are entirely isolated from each other as well as from the material of the magnetic circuits 21.

The hot fluid in the first external pipe arrangement 31 transfers heat to fluid in a first intermediate pipe arrangement 35 via a first heat exchanger 36 and the cold fluid in the second external pipe arrangement 33 transfers cold to fluid in a second intermediate pipe arrangement 37 via a second heat exchanger 38. Each of the first and second intermediate pipe arrangements 35, 37 is connected between a first valve arrangement 39 and a second valve arrangement 40 to transport fluid from the first valve arrangement 39 to the second valve arrangement 40. The first and second valve arrangements 39, 40 are advantageously based on rotating valves, examples of which being disclosed in JP 7107764, the contents of which being hereby incorporated by reference.

It shall be appreciated that the outer part may be exchanged for any other kind of arrangement for transferring heat and cold in the heat exchangers 36 and 38. For instance, heat may be transferred to fluid in the first intermediate pipe arrangement 35 in the first heat exchanger 36 via an incinerator, hot sand, a solar heating panel, or similar.

Finally, a first 41, a second 42, and a third 43 internal pipe arrangement are each connected between the second valve arrangement 40 and the first valve arrangement 39 via a respective one of the magnetic circuits 21.

A fluid is flowing in the inner part of the low frequency alternating heat and cold distribution system 12, which comprises the intermediate 35, 37 and internal 41, 42, 43 pipe arrangements and the first 39 and second 40 valve arrangements. The inner part thus provides a closed fluid loop.

The second valve arrangement 40 is provided for alternately switching hot fluid from the first intermediate pipe arrangement 35 and cold fluid from the second intermediate pipe arrangement 37 into each one of the first, second and third internal pipe arrangements 41, 42, 43, preferably with a 120° phase shift there in between. Thus, the second valve arrangement 40 "chops" the hot and cold fluids and forms trains of alternating hot and cold fluid pulses, which are fed into each of the internal pipe arrangements. As the hot and cold fluid pulses pass by, or through holes in, a thermomagnetic material of the magnetic circuits 21, the thermomagnetic material will be alternately heated above and cooled below the phase transition temperature as was described above in connection with the embodiment of Fig. 2.

The terms "hot fluid" and "cold fluid" as used in the present text are intended to indicate "fluid having a temperature above the phase transition temperature of the thermomagnetic material of the portion 21b of the magnetic circuit" and "fluid having a temperature below the phase transition temperature of the thermomagnetic material of the portion 21b of the magnetic circuit", respectively.

The thermomagnetic material can be provided as parallel sheets or plates preferably arranged in parallel to one another, granulates, small spheres, wires, fabrics or similar allowing the fluid, in a laminar or turbulent flow, to exchange heat with the thermomagnetic material with large contact surface.

After having passed the thermomagnetic material the temperature variation between the hot and cold fluid pulses is smaller and smoother. The trains of hot and cold fluid pulses are then returned in the respective internal pipe arrangements 41, 42, 43 to the first valve arrangement 39, which is synchronized with the trains of hot and cold fluid pulses.

The first valve arrangement 39 is thus provided for alternately switching the hotter fluid pulses from the first, second and third internal pipe arrangements 41, 42, 43 into the first intermediate pipe arrangement 35 and the colder fluid pulses from the first, second and third internal pipe arrangements 41, 42, 43 into the second intermediate pipe arrangement 37. Hereby, the hotter and colder fluid pulses are returned to the respective intermediate pipe arrangement, from which they were originating. The fluid in the first intermediate pipe arrangement 35 is then returned to the first heat exchanger 36 in order to be heated again and the fluid in the second intermediate pipe arrangement 37 is then returned to the second heat exchanger 38 in order to be cooled again. The fluid in the inner part is driven in a single direction by feed pumps 44, 45. The rotating valves 39, 40 of Fig. 3 are advantageously mounted on a single shaft to be rotated simultaneously/synchronously with a suitable phase shift there in between.

The fluid used in the inner closed loop may be water or any other fluid, optionally to which additives have been added. Additives that reduce corrosion with respect to the thermomagnetic material may be added. Additives can also be used to reduce the viscosity and/or increase the thermal conductivity. Other additives, such as thermal salts or similar with a phase transition adjusted to the phase transition temperature of the thermomagnetic material to thereby increase the heat capacity of the fluid, may additionally or alternatively be added.

The provision of inner and outer parts separated from one another is not necessary. For instance, the hot fluid may be taken directly from e.g. a (hydro)thermal bore hole and be returned via a secondary or return bore hole.

The thermomagnetic material can be gadolinium or an alloy comprising gadolinium. Alternatively, the thermomagnetic material with the suitable phase transition temperature is any of bismuth, zinc, antimony, tellurium, selenium, lead, silicon, germanium, tin, magnesium, manganese, arsenic, nickel, lanthanum, gallium, phosphorus, calcium, barium, strontium, ytterbium, iron or any alloy or compound thereof. Note that not all of the above elements are magnetic, but can in such instance be used with a thermomagnetic material to modify its magnetic phase transition characteristics. Some of the above elements may be present in the thermomagnetic material of the invention as an oxide, or in any other kind of chemical compound.

Preferably, the magnetic circuit with the thermomagnetic material is arranged such that a heat transfer per unit area between the alternating distribution of heat and cold and the thermomagnetic material is essentially constant along a distribution direction of the alternating distribution of heat and cold. This may be realized in several manners.

The magnetic circuit 21 comprises in one embodiment a layer, preferably a thermally insulating layer, on top of the thermomagnetic material having a heat transfer capability per unit area that varies along the distribution direction of the alternating distribution of heat and cold. The varying heat transfer capability per unit area can be achieved by the layer having a varying thickness or material composition along the distribution direction.

In another embodiment the constant heat transfer per unit area between alternating distribution of heat and cold and the thermomagnetic material is achieved by an inhomogeneous structure of the bulk material of the thermomagnetic material. The interface surface area between the distribution of heat and cold and the thermomagnetic material increases along the distribution direction of the alternating distribution of heat and cold.

The process control system 15 may be provided for measuring the performance of the electricity generation system and optimizing the power output, e.g. as was described with reference to Fig. 2. Further sensor devices (not illustrated) may be provided for measuring flow or mass rates of the temperature varying fluid, and the process control system 15 may be provided for controlling the flow or mass rates of the temperature varying fluids as well as the speeds of the rotating valves. Further, the inductance in the resonance circuit can be adjusted by changing the temperature difference of the heat and cold. Water fluid can be stopped or adjusted and the valve frequency can be adjusted.

The system of Fig. 3 may also comprise a protection system and an error indication system as disclosed with reference to the systems of Figs. 1 and 2.

For example, water leakage can be controlled with pressure sensor, temperature sensors, and a trip signal. Pumps and valves can be voltage and/or current monitored. The power output measurements can be used for error detection. Electrical equipment must be protected from water, and as consequence thereof a sufficient drain or reservoir need to be installed.

The electricity generation system of the invention is advantageously used for the generation of electric power by using any of waste heat, combustion heat, thermal storage reservoir energy, geothermal energy, solar radiation, solar thermal energy, or ocean thermal energy.

Fig. 4 displays schematically an electricity generation network 41 comprising a collection grid 42 and a plurality of the electricity generation system 11 of any of Figs. 1-3 connected to the collection grid. The network comprising a single output 43 for outputting the generated electricities from the electricity generation systems 11 to a transmission grid.

The collection grid 42a-b is operated at MV voltage, is an AC or DC grid, and/or is arranged as a star, radial, or meshed grid. In the illustrated example a local collection grid 42a interconnecting neighboring electricity generation systems 11 is operated in the range 1-100 kV, whereas a collection grid 42b interconnecting the local collection grids 42a is operated at 10-130 kV. Each of the electricity generation systems 11 is connected to the local grid via a transformer 44 or DC/DC converter for transferring the generated electricity from the electricity generation system to the local transmission grid 42a.

## Claims

1. An electricity generation system (11) comprising:
- a low frequency alternating heat and cold distribution system (12) provided for alternately distributing heat and cold at low frequency;
- a heat-electricity conversion system (13) operatively connected to said low frequency alternating heat and cold distribution system and provided for generating electricity in response to said alternately distributed heat and cold;
- an electric power delivery system (14) operatively connected to said heat-electricity conversion system and provided for distributing said generated electricity; and
- a process control system (15) operatively connected to said low frequency alternating heat and cold distribution system, to said heat-electricity conversion system, and to said electric power delivery system in order to control the operations thereof.

2. The system of claim 1 wherein said low frequency alternating heat and cold distribution system is a system for circulation of a medium of alternating temperature.

3. The system of claim 2 wherein said system for circulation of heat and cold is a system for unidirectional or bidirectional continuous circulation of said medium.

4. The system of any of the preceding claims wherein said low frequency alternating heat and cold distribution system comprises an arrangement (35) for receiving a hot medium, an arrangement (37) for receiving a cold medium, and at least one arrangement (39, 40) for mixing said hot and cold media.

5. The system of any of the preceding claims wherein said low frequency is between about 0.1 and 10 Hz.

6. The system of any of the preceding claims wherein said heat and cold has a maximum temperature difference between about 5 and 50 K.

7. The system of any of the preceding claims wherein said heat-electricity conversion system is a stationary system without movable mechanical parts.

8. The system of any of the preceding claims wherein said heat-electricity conversion system comprises several heat-electricity conversion stages operating in parallel or in series.

9. The system of any of the preceding claims wherein said heat-electricity conversion system comprises a fixedly arranged thermodynamic material.

10. The system of claim 9 wherein said heat-electricity conversion system is formed such that a heat transfer per unit area between the alternating distribution of heat and cold and the fixedly arranged thermodynamic material is essentially constant, thus creating an essentially constant temperature in the thermodynamic material along a distribution direction of the alternating distribution of heat and cold.

11. The system of any of the preceding claims wherein said heat-electricity conversion system is provided for generating a periodically varying electric current.

12. The system of any of the preceding claims wherein said electric power delivery system comprises means for powering said heat-electricity conversion system.

13. The system of any of the preceding claims wherein the low frequency alternating heat and cold distribution system is provided for alternately distributing the heat and cold periodically; the heat-electricity conversion system is provided for generating the electricity periodically; and the process control system is provided for controlling the period of the generated electricity and the period of the distribution of heat and cold so that one of the periods is n times the other one of the periods, where n is an integer.

14. The system of any of the preceding claims wherein said process control system comprises
- sensing means (29a-c) provided for sensing a parameter of any of said low frequency alternating heat and cold distribution system, said heat-electricity conversion system, and said electric power delivery system; and
- said process control system is provided for controlling any of said low frequency alternating heat and cold distribution system, said heat-electricity conversion system, and said electric power delivery system in response to said sensed parameter.

15. The system of any of the preceding claims wherein said process control system comprises
- sensing means (29a-c) provided for sensing a parameter of one of said low frequency alternating heat and cold distribution system, said heat-electricity conversion system, and said electric power delivery system; and
- said process control system is provided for controlling another one of said low frequency alternating heat and cold distribution system, said heat-electricity conversion system, and said electric power delivery system in response to said parameter sensed in said one of said low frequency alternating heat and cold distribution system, said heat-electricity conversion system, and said electric power delivery system.

16. The system of any of the preceding claims wherein said process control system comprises
- sensing means (29a-c) provided for sensing a respective parameter of each of said low frequency alternating heat and cold distribution system, said heat-electricity conversion system, and said electric power delivery system; and
- said process control system is provided for controlling said low frequency alternating heat and cold distribution system, said heat-electricity conversion system, and said electric power delivery system in response to said sensed parameters.

17. The system of any of the preceding claims wherein said process control system comprises
- sensing means (29a-c) provided for sensing a plurality of parameters of each of said low frequency alternating heat and cold distribution system, said heat-electricity conversion system, and said electric power delivery system; and
- said process control system is provided for controlling any of said low frequency alternating heat and cold distribution system, said heat-electricity conversion system, and said electric power delivery system in response to said sensed plurality of parameters.

18. The system of any of claims 14-17 wherein said parameter or said parameters include any of a volume or mass flow, a temperature, a pressure, a wave shape, a pulse length, a frequency, a phase, a magnetic flux or flux density, a voltage, a current, an impedance, and/or a power.

19. The system of any of claims 14-18 wherein said process control system is provided for controlling any of a magnitude or magnitude per time unit of the alternately distributed heat and cold, the low frequency of the alternately distributed heat and cold, the temperature of the alternately distributed heat and cold, an active power cycle, an active and/or reactive power of said distributed generated electricity, and/or a frequency and phase of said distributed generated electricity in response to said sensed parameter or said sensed parameters.

20. The system of any of the preceding claims wherein said process control system comprises a controllable electric circuit (27) operatively connected to said heat-electricity conversion system and said electric power delivery system, and said process control system is provided for controlling an impedance, a voltage, and/or a current of said controllable electric circuit in order to control the operation of said heat-electricity conversion system and/or said electric power delivery system.

21. The system of claim 20 wherein said process control system is provided for controlling said controllable electric circuit during initiation, and/or synchronization of, electrical oscillations of the heat-electricity conversion system to the temperature variation of the alternately distributed heat and cold during start-up of said system.

22. The system of any of the preceding claims further comprising a heat and cold storage system (12a) provided for storing heat and cold.

23. The system of claim 22 comprising a heat and cold extracting system (12b) operatively connected to said low frequency alternating heat and cold distribution system and to said heat and cold storage system (12a) and provided for extracting heat and/or cold from said heat and cold storage system (12a).

24. The system of claim 23 wherein said heat and cold extracting system (12b) is provided for extracting heat and/or cold from said heat and cold storage system (12a) in response to the availability of heat and/or cold from other sources..

25. The system of any of claims 22-24 wherein said heat and cold storage system comprises one or more solar ponds, fluid reservoirs, salt based storages, ceramic brick storages, and/or rock based storages.

26. The system of any of the preceding claims further comprising a protection system (16) for protecting said low frequency alternating heat and cold distribution system, said heat-electricity conversion system, said electric power delivery system, and/or said process control system.

27. The system of claim 26 wherein said protection system comprises a leakage sensor for sensing a leakage in said low frequency alternating heat and cold distribution system and is providing for shutting down said low frequency alternating heat and cold distribution system in response to said sensed leakage.

28. The system of claim 26 or 27 wherein said protection system comprises a drainage or reservoir for handling a leakage in said low frequency alternating heat and cold distribution system.

29. The system of any of claims 26-28 wherein said protection system comprises a protection circuit including an arc eliminator (30) to limit a breakdown or a permanent failure in said heat-electricity conversion system.

30. The system of any of the preceding claims further comprising an error indication system (17) for indicating an error in the operation of said low frequency alternating heat and cold distribution system, said heat-electricity conversion system, said electric power delivery system, and/or said process control system.

31. The system of claim 30 wherein said protection system is provided for breaking a current in said heat-electricity conversion system and/or in said electric power delivery system and/or for changing an active and/or reactive power of said distributed generated electricity in response to an indicated error.

32. An electricity generation network (41) comprising a collection grid (42a-b) and a plurality of the system of any of claims 1-31 connected to the collection grid.

33. The network of claim 32 comprising a single output (43) for outputting the generated electricities from the electricity generation systems to a transmission grid.

34. The network of claim 32 or 33 wherein the collection grid is operated at MV voltage, is an AC or DC grid, and/or is arranged as a star, radial, or meshed grid.

35. The network of any of claims 32-34 comprising, for each of the electricity generation systems, a transformer (44) or DC/DC converter for transferring the generated electricity from the electricity generation system to the transmission grid.
